# EUROPEAN PATENT APPLICATION

(11) **EP 3 179 718 A2**
(43) Date of publication of application: **14.06.2017**
(21) Application number: 16202485.5
(22) Date of filing: 06.12.2016
(51) Int. Cl.: H04N 9/31, G02B 27/01, H01S 5/06

(54) **PROJECTOR**

(30) Priority: 07.12.2015 JP 2015238747
(71) Applicant: Funai Electric Co., Ltd., Daito city Osaka 574-0013 (JP)
(72) Inventor: TAKEMOTO, Seiji, Osaka, Osaka 574-0013 (JP)
(74) Representative: Osha Liang

(57) **Abstract**

A projector (10) includes a plurality of light-sources (103, 104, 105) that outputs a laser light, a detector that detects a light amount of the laser light, and a controller (117) that controls an output of the light-sources based on a characteristic indicating a relationship between a forward current value and a light output when a current value of the light-sources is smaller than a predetermined current value. When the current value of the light-sources is greater than or equal to the predetermined current value, the controller (117) controls the output of the light-sources (103, 104, 105) based on the detected light amount. The predetermined current value is a current value that can be laser-oscillated.

## Description

### BACKGROUND

### Technical Field

The present invention generally relates to a projector and particularly relates to a projector used in a head-up display device or the like.

### Related Art

Conventional projectors project an image by scanning a laser light (for example, see patent literature 1). Patent literature 1 discloses a technique whereby a laser light can be controlled even in a low-brightness state by having, as an approximation, a relationship between a current value and a light output value in the low-brightness state in order to control the laser light even in the low-brightness state.

Patent Literature 1: JP2012-108397A

### SUMMARY

However, with a laser light, a relationship between a current value and a light output value differs according to color components such as RGB. With the projector (display device) disclosed in patent literature 1, this relationship is not considered. Because of this, with the projector (display device) disclosed in patent literature 1, a color balance is lost in the low-brightness state and, when a low-brightness image is displayed on a display surface, a color shift is generated.

One or more embodiments of the present invention provides a projector that can reduce generation of a color shift even when a low-brightness image is displayed on a display surface.

A projector according to one or more embodiments of the present invention may comprise: a plurality of laser light-sources that outputs laser lights of mutually different color components; and a controller that controls respective outputs of the plurality of laser light-sources using a characteristic approximation that is an approximation that approximates an Injection current-Light output (IL) characteristic indicating a relationship between a forward current and a light output of each of the plurality of laser light-sources and consists of a plurality of approximations for each section where the IL characteristic is divided by one or more division points; wherein an error between a value of the IL characteristic expressed by the characteristic approximation and a value of the IL characteristic actually measured is within a predetermined range, and the controller controls the outputs of each of the plurality of laser light-sources so a ratio of light outputs at corresponding division points of the plurality of laser light-sources becomes a white balance ratio.

As a result, even at a low light amount smaller than a light amount that cannot be detected by a light detector, by using the characteristic approximation, which approximates a characteristic of a low-light-amount region (low-brightness-region characteristic) of actually measured values measured in advance, respective outputs of the plurality of laser light-sources can be controlled. Moreover, because the characteristic approximation of each of the plurality of laser light-sources is calculated in consideration of the white balance, a projector can be realized that can reduce generation of a color shift even in a situation of displaying a low-brightness image on a display surface.

Furthermore, a projector according to one or more embodiments of the present invention may comprise: a plurality of laser light-sources that outputs laser lights of mutually different color components; and a controller that controls respective outputs of the plurality of laser light-sources using a characteristic approximation that is an approximation that approximates a characteristic indicating a relationship between a forward current and a light output of each of the plurality of laser light-sources and consists of a plurality of approximations for each section where the IL characteristic is divided by one or more division points; wherein an error between a value of the IL characteristic expressed by the characteristic approximation and a value of the IL characteristic actually measured is within a predetermined range, and the controller controls the outputs of each of the plurality of laser light-sources so current values at corresponding division points of the plurality of laser light-sources become identical.

The projector according to one or more embodiments of the present invention may further comprise a correction unit that corrects the characteristic approximation. In a situation where a relationship of the light output relative to a forward current value in each of the plurality of laser light-sources received by the light detector is changed, the correction unit may correct the respective characteristic approximations of the plurality of laser light-sources.

Even in a situation where an output characteristic shifts due to a change in a temperature or a change over time, the characteristic approximation can be corrected in correspondence thereto; therefore, generation of the color shift of the low-brightness image displayed on the display surface can be reduced.

According to one or more embodiments of the present invention, in the situation where the relationship of the light output to the forward current value in each of the plurality of laser light-sources received by the light detector is changed, the correction unit may correct the respective characteristic approximations of the plurality of laser light-sources to become values continuous with a lower limit indicated by the relationship of the light output to the forward current.

One or more embodiments of present invention can not only be realized as a projector but can also be realized as a control method whose steps are processing executed by a characteristic processor included in the projector. Moreover, it can also be realized as a program for causing the computer to function as the characteristic processor included in the projector or a program that causes the computer to execute characteristic steps included in the control method. Moreover, it is needless to say that such a program can be distributed via a non-temporary recording medium that can be read by a computer such as a CD-ROM (compact disc read-only memory) or a communication network such as the Internet.

According to one or more embodiments of the present invention, a projector includes a plurality of light-sources that outputs a laser light, a detector that detects a light amount of the laser light, and a controller that controls an output of the light-sources based on a characteristic indicating a relationship between a forward current value and a light output when a current value of the light-sources is smaller than a predetermined current value.

According to one or more embodiments of the present invention, generation of the color shift may be reduced even when the low-brightness image is displayed on the display surface.

### BRIEF DESCRIPTION OF DRAWINGS

FIG. 1 is a diagram illustrating an installation example of a HUD device according to a first embodiment of the present invention.
FIG. 2 is a diagram illustrating an example of a scenery viewed by a user through a windshield according to one or more embodiments of the present invention.
FIG. 3 is a block diagram illustrating an example of a configuration of the HUD device according to the first embodiment of the present invention.
FIG. 4 is a graph illustrating an example of a relationship between an input current and an output of a laser light-source actually measured in a pre-shipment inspection.
FIG. 5A is a graph illustrating an example of a relationship between the input current and the output of the laser light-source that can be measured by a photodiode.
FIG. 5B is an example of a graph where a characteristic approximation is added to the graph of FIG. 5A according to the first embodiment of the present invention.
FIG. 6 is a block diagram illustrating an example of a configuration of a HUD device according to a second embodiment of the present invention.
FIGS. 7A and 7B are graphs illustrating an example of a characteristic approximation of a laser light-source and an approximation error thereof, respectively.
FIG. 8A is a graph illustrating an example of a characteristic approximation in a laser light-source of a red component.
FIG. 8B is a graph illustrating an example of an approximation error of the characteristic approximation in the laser light-source of the red component.
FIG. 9A is a graph illustrating an example of a characteristic approximation in a laser light-source of a green component.
FIG. 9B is a graph illustrating an example of an approximation error of the characteristic approximation in the laser light-source of the green component.
FIG. 10A is a graph illustrating a characteristic approximation in the laser light-source of the red component before adjustment and actually-measured characteristic values according to the second embodiment of the present invention.
FIG. 10B is a graph illustrating an approximation error in FIG. 10A according to the second embodiment of the present invention.
FIG. 10C is a graph illustrating a characteristic approximation in the laser light-source of the green component before adjustment and actually-measured characteristic values according to the second embodiment of the present invention.
FIG. 10D is a graph illustrating an approximation error in FIG. 10C according to the second embodiment of the present invention.
FIG. 11A is a graph illustrating the characteristic approximation in the laser light-source of the red component after adjustment and the actually-measured characteristic values according to the second embodiment of the present invention.
FIG. 11B is a graph illustrating an approximation error in FIG. 11A according to the second embodiment of the present invention.
FIG. 11C is a graph illustrating the characteristic approximation in the laser light-source of the green component after adjustment and the actually-measured characteristic values according to the second embodiment of the present invention.
FIG. 11D is a graph illustrating an approximation error in FIG. 11C according to the second embodiment of the present invention.
FIG. 12A is a graph illustrating an example of a characteristic approximation, division points, and the approximation error in a red laser light-source before adjustment according to the second embodiment of the present invention.
FIG. 12B is a graph illustrating an example of a characteristic approximation, division points, and an approximation error in a green laser light-source before adjustment according to the second embodiment of the present invention.
FIG. 12C is a graph illustrating an example of a characteristic approximation, division points, and an approximation error in a blue laser light-source before adjustment according to the second embodiment of the present invention.
FIG. 13A is a graph illustrating an example of the characteristic approximation, the division points, and the approximation error in the red laser light-source after adjustment according to the second embodiment of the present invention.
FIG. 13B is a graph illustrating an example of the characteristic approximation, the division points, and the approximation error in the green laser light-source after adjustment according to the second embodiment of the present invention.
FIG. 13C is a graph illustrating an example of the characteristic approximation, the division points, and the approximation error in the blue laser light-source after adjustment according to the second embodiment of the present invention.
FIG. 14 is a block diagram illustrating an example of a configuration of a HUD device according to a third embodiment of the present invention.
FIG. 15 is a block diagram illustrating a configuration of a main CPU according to the third embodiment of the present invention.
FIG. 16 is a graph illustrating an example of a characteristic of a laser light-source that changes according to a temperature change or the like according to the third embodiment of the present invention.
FIG. 17 is a graph illustrating an example of the characteristic approximation of the laser light-source corrected by a correction unit according to the third embodiment of the present invention.

### DETAILED DESCRIPTION

Embodiments of the present invention will be described in detail below with reference to the drawings. In the following description of embodiments of the invention, numerous specific details are set forth in order to provide a more thorough understanding of the invention. However, it will be apparent to one of ordinary skill in the art that the invention may be practiced without these specific details. In other instances, well-known features have not been described in detail to avoid obscuring the invention.

A projector according to one or more embodiments of the present invention is described below with a head-up display ("HUD" herein below) device as an example. A HUD device is a system that, by projecting an image on a windshield of an automobile, projects a virtual image ahead of the windshield (outside the automobile) to project an image in a visual field of a user (driver).

### (First Embodiment)

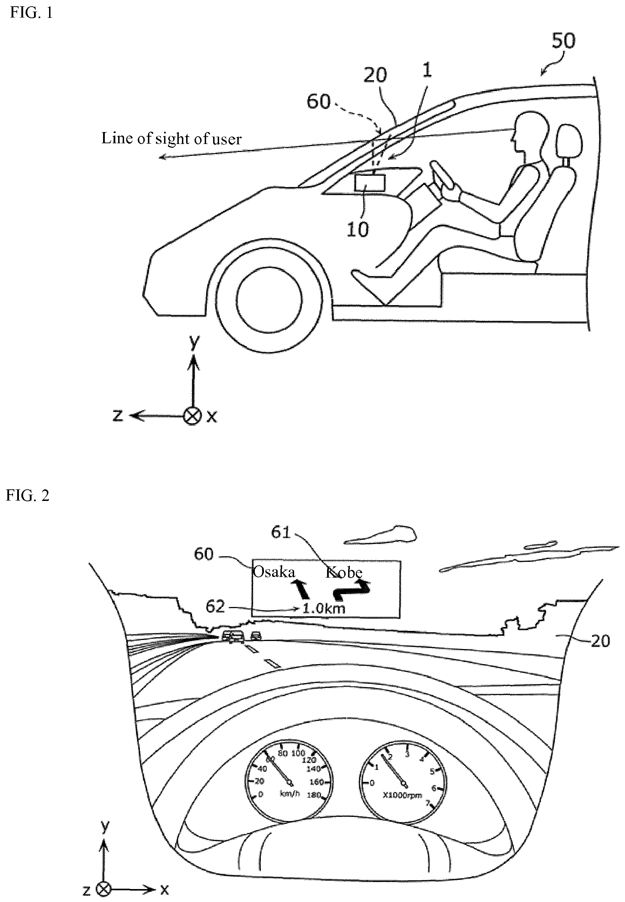

FIG. 1 is a diagram illustrating an installation example of a HUD device according to a first embodiment of the present invention. As illustrated in FIG. 1, a HUD device 1 includes a projector 10 and a combiner 60 (configuring a transparent display panel).

The projector 10 is installed in transportation equipment such as an automobile 50 and is installed, for example, on a dashboard of the automobile 50. The combiner 60 is a display surface installed to a portion of a windshield 20 of the automobile 50. The projector 10 projects an image to the combiner 60 by irradiating a light to the combiner 60. Because the combiner 60 is configured from a polarizing element, a wavelength selection element, a half mirror, and the like, the image projected by the projector 10 is displayed superimposed on a scenery outside the automobile. Note that the windshield 20 itself may also function as the combiner 60.

FIG. 2 is a diagram illustrating an example of a scenery viewed by the user through the windshield. As described above, the combiner 60 is installed on the windshield 20. The image projected from the projector 10 is displayed on the combiner 60. As illustrated in FIG. 2, the projector 10 has a function of displaying on the combiner 60 information relating to car navigation (for example, route information to a destination), information relating to the automobile (for example, fuel consumption information), and the like. For example, the projector 10 displays on the combiner 60 route information 61 to the destination ("Osaka," "Kobe," and "arrows" indicating routes respectively corresponding thereto) and an image (an example of a content image) illustrating distance information 62 to the destination ("1.0 km"). As illustrated in FIG. 2, because the image projected from the projector 10 is displayed in the scenery ahead, the user can acquire information useful in driving without diverting a line of sight while driving the automobile 50.

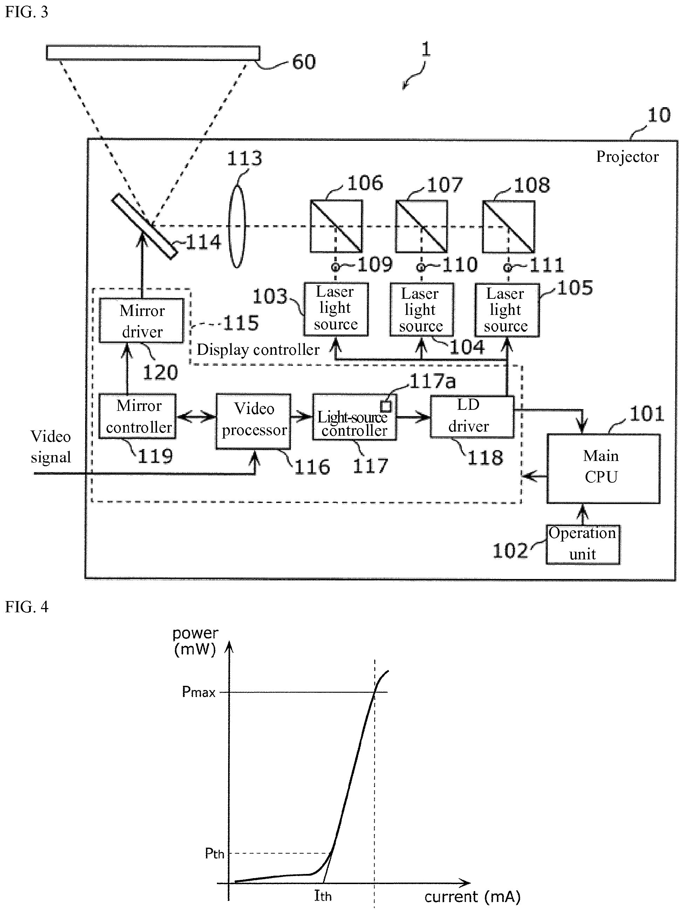

FIG. 3 is a block diagram illustrating an example of a configuration of the HUD device according to the first embodiment of the present invention.

As described above, the HUD device 1 includes the projector 10 and the combiner 60.

The projector 10 displays an image by irradiating a laser light. In the first embodiments of the present embodiment, the projector 10 includes a main central processing unit ("CPU" herein below) 101, an operation unit 102, laser light-sources 103 to 105 (configuring a light-source), beam splitters 106 to 108, photodiodes 109 to 111, a lens 113, a microelectromechanical system ("MEMS" herein below) mirror 114, and a display controller 115.

The main CPU 101 controls each unit of the projector 10.

The operation unit 102 accepts operations by the user such as an operation of turning on the HUD device 1 (projector 10), an operation of changing a projection angle of the image, and an operation of changing a color tone or a brightness of the image. The operation unit 102 may be configured by, for example, a hardware button or a software button or may be configured by a remote controller and a receiver that receives an electromagnetic wave sent from the remote controller.

The laser light-sources 103 to 105 are respectively laser light-sources that output laser lights of different color components. Specifically, the laser light-source 103 is a laser diode that causes, for example, a blue laser light to pass through the beam splitter 106 and the lens 113 to be irradiated to the MEMS mirror 114. Moreover, the laser light-source 104 is a laser diode that causes, for example, a green laser light to pass through the beam splitter 107 and the lens 113 to be irradiated to the MEMS mirror 114. Moreover, the laser light-source 105 is a laser diode that causes, for example, a red laser light to pass through the beam splitter 108 and the lens 113 to be irradiated to the MEMS mirror 114.

The photodiodes 109 to 111 are respectively light detectors that detect light outputs output by each of a plurality of laser light-sources. Specifically, the photodiodes 109 to 111 respectively detect light amounts of the laser lights output from the laser light-sources 103 to 105.

The MEMS mirror 114 projects the image toward the combiner 60. Moreover, the MEMS mirror 114 high-speed scans a horizontal direction by resonant driving and low-speed scans a vertical direction by DC driving. Drive control of the MEMS mirror 114 is performed by the display controller 115, which is described below.

The display controller 115 includes a video processor 116, a light-source controller 117, an LD (laser diode) driver 118, a mirror controller 119, and a mirror driver 120.

The video processor 116 performs a control for projecting the image to the combiner 60 based on a video signal input from the outside. Specifically, the video processor 116 controls driving of the MEMS mirror 114 via the mirror controller 119 based on this video signal and controls irradiation of the laser lights by the laser light-sources 103 to 105 via the light-source controller 117.

The light-source controller 117 has a memory 117a and is a controller that controls an output of each laser light-source 103 to 105. The light-source controller 117 controls the output of each laser light-source 103 to 105 so current values of the laser light-sources 103 to 105 at corresponding division points become identical and controls the output of each laser light-source 103 to 105 so a ratio of light outputs of the laser light-sources 103 to 105 at the corresponding division points becomes a white-balance ratio. In the first embodiment of the present invention, stored in the memory 117a are characteristic approximations that are approximations that approximate Injection current-Light output (IL) characteristics indicating relationships between a forward current and the light output of each laser light-source 103 to 105 in a low-light-amount region smaller than a detectable light amount (predetermined light amount) that each photodiode 109 to 111 can detect. In a situation where the light amount of the light output of each laser light-source 103 to 105 is smaller than the detectable light amount that can be detected by each photodiode 109 to 111, the light-source controller 117 uses the characteristic approximations stored in the memory 117a to control the output of each laser light-source 103 to 105. Meanwhile, in a situation where the light amount of the light output of each laser light-source 103 to 105 is greater than or equal to the detectable light amount, the light-source controller 117 controls the output of each laser light-source 103 to 105 based on this light output. Specifically, the light-source controller 117 controls the LD driver 118 based on a control by the video processor 116 to control irradiation of the laser lights by the laser light-sources 103 to 105. The light-source controller 117 performs a control for irradiating, from the laser light-sources 103 to 105, laser lights of colors corresponding to each pixel of the image according to a scanning timing of the image by the MEMS mirror 114.

Note that the characteristic approximations are not limited to a situation of approximating the IL characteristics indicating the relationships between the forward current and the light output of each laser light-source 103 to 105 in the low-light-amount region and may approximate IL characteristics in an entire region of each laser light-source 103 to 105.

The LD driver 118 adjusts the light amounts of the laser light-sources 103 to 105 by supplying a drive current to the laser light-sources 103 to 105.

The mirror controller 119 controls the mirror driver 120 based on a control by the video processor 116 to control driving of the MEMS mirror 114. That is, by controlling a tilt of the MEMS mirror 114, the mirror controller 119 scans on the combiner 60 the laser lights irradiated from the laser light-sources 103 to 105. By this, the mirror controller 119 projects the image to the combiner 60. That is, the image indicating the route information 61, the distance information 62, and the like projected to the combiner 60 is formed by the laser light-sources 103 to 105, which are for image formation.

The mirror driver 120 changes the tilt of the MEMS mirror 114 by supplying a drive signal to the MEMS mirror 114.

### (Characteristic Approximation)

The characteristic approximations mentioned above are described below.

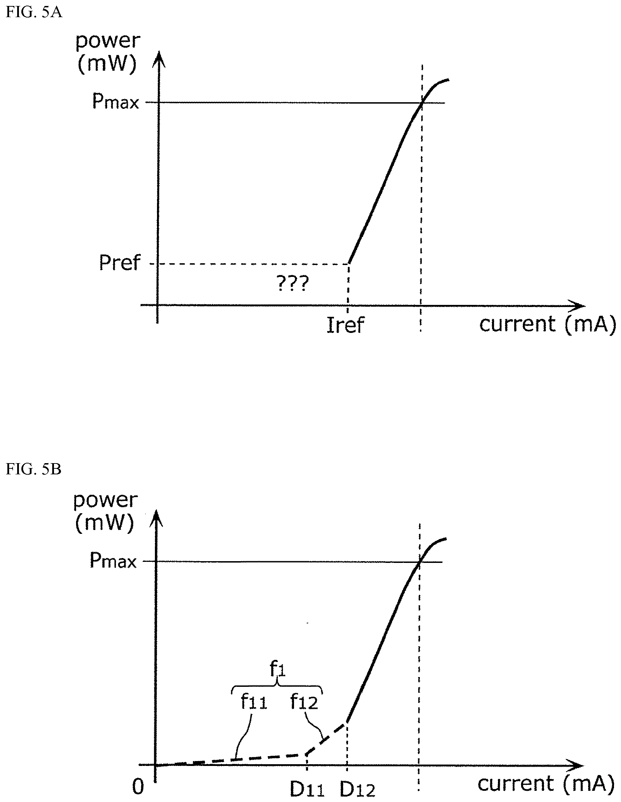

FIG. 4 is a graph illustrating an example of a relationship between an input current (forward current) and an output of a laser light-source actually measured in a pre-shipment inspection. FIG. 5A is a graph illustrating an example of a relationship between the input current and the output of the laser light-source that can be measured by a photodiode. FIG. 5B is an example of a graph where a characteristic approximation is added to the graph of FIG. 5A.

In the pre-shipment inspection of the laser light-source, using a high-performance photodiode or the like that can detect even a low light amount becoming a low brightness, a characteristic of the laser light-source indicating the relationship between the input current and the output of the laser light-source such as that illustrated in FIG. 4 can be actually measured. Because of this, an IL characteristic (low-light-amount-region characteristic) of a region of a low light amount (low brightness) that cannot be detected by the photodiodes 109 to 111 of the projector 10, such as a light output (Pth) equal to or less than an oscillation threshold current value Ith (predetermined current value), can also be measured. The oscillation threshold current value is a current value that can be laser-oscillated by the photodiodes 109 to 111.

In a situation where the light output of the laser light-source is a low light amount such as a light output at a forward current value smaller than the oscillation threshold current, an S/N (signal-to-noise ratio) of the photodiodes 109 to 111 of the projector 10 worsens such that detection cannot be performed. In other words, as illustrated in FIG. 5A for example, a photodiode of the projector 10 such as the photodiode 109 cannot detect a light output of the laser light-source smaller than a light amount of a lower limit (light amount P_{ref}) of a range of detectable light amounts. Because of this, the light-source controller 117 does not receive feedback of the light output from the photodiode in a region of low light amounts (low brightness) smaller than a light amount of a light output of this lower limit and therefore cannot control irradiation of the laser light-sources 103 to 105.

Therefore, in the first embodiment of the present invention, as illustrated in FIG. 5B, a characteristic approximation is used that approximates the IL characteristic (low-light-amount-region characteristic) that the photodiode of the projector 10 such as the photodiode 109 cannot detect. By this, the light-source controller 117 may control the respective outputs of the plurality of laser light-sources by using the characteristic approximations even in the regions of the low light amounts (low brightness) smaller than the light amounts of the light outputs that the photodiodes 109 to 111 cannot detect.

Here, the characteristic approximation is calculated based on an IL characteristic (low-light-amount-region characteristic) actually measured at the pre-shipment inspection and consists of a plurality of approximations for each section where this IL characteristic (low-light-amount-region characteristic) is divided by one or more division points. The division points become positions of inflection points connecting the different approximations configuring the characteristic approximation. For example, the plurality of approximations may be linear expressions in view of a capacity and the like of the memory 117a. Therefore, in the first embodiment of the present invention, as illustrated in FIG. 5B for example, the characteristic approximation is configured by an approximation f₁ consisting of linear approximations f₁₁, f₁₂ of two sections respectively divided by division points D₁₁, D₁₂.

Thus, according to one or more embodiments of the present invention, the projector 10 may comprise the laser light-sources 103 to 105 that outputs a laser light, the photodiodes 109 to 111 that detects a light amount of the laser light, and the light-source controller 117 that controls an output of the light-sources based on the IL characteristics when a current value of the laser light-sources 103 to 105 is smaller than a predetermined current value such as the oscillation threshold current value.

### (Effects)

As described above, the projector 10 according to the first embodiment of the present invention may control the respective outputs of the plurality of laser light-sources by using the characteristic approximations, which approximate IL characteristics of low-light-amount regions (low-light-amount-region characteristics) of actual measurement values measured in advance, even in the regions of the low light amounts (low brightness) smaller than the light amounts of the light outputs that cannot be measured by the photodiodes 109 to 111.

By this, the projector 10 according to the first embodiment of the present invention may reduce generation of a color shift even when a low-brightness image is displayed on the display surface.

Furthermore, the characteristic approximation is calculated to consist of a plurality of linear expressions. As a result, because a memory capacity of the memory 117a is conserved, the projector 10 that can reduce the generation of the color shift may be realized at a lower cost.

### (Second Embodiment)

In the first embodiment of the present invention, it is described how the respective light outputs of the plurality of laser light-sources can be controlled using the characteristic approximations even in the regions of the low light amounts (low brightness). However, the characteristic of the laser light-source (relationship between a current value and a light output value) differs according to the color components such as RGB. Because of this, even if the light outputs of the low-light-amount regions of the plurality of laser light-sources are respectively controlled using individual characteristic approximations, there is a possibility that a color balance will be lost in the regions of the low light amounts.

Therefore, in a second embodiment of the present invention, it is described how the light output of each of the plurality of laser light-sources is controlled using an individual characteristic approximation calculated so the color balance is not lost even in the low-light-amount region.

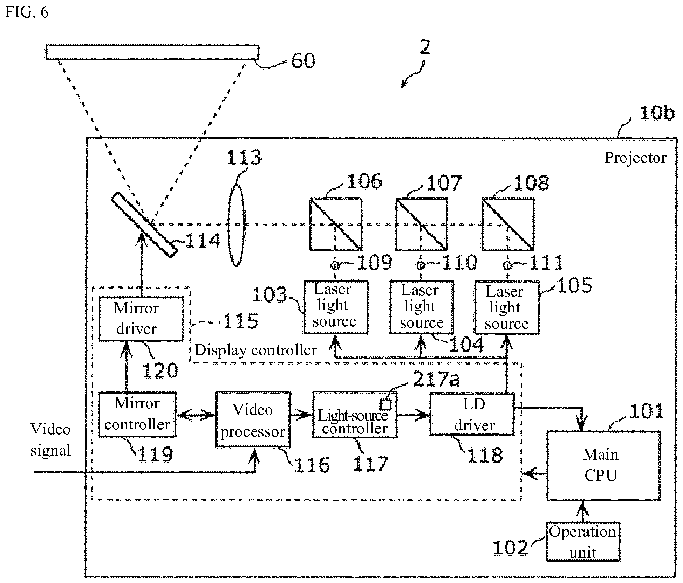

FIG. 6 is a block diagram illustrating an example of a configuration of a HUD device according to in the second embodiment of the present invention. Elements similar to those in FIG. 3 are labeled with the same reference signs, and detailed description is omitted.

A HUD device 2 illustrated in FIG. 6 differs from the HUD device 1 according to the first embodiment of the present invention in a configuration of a memory 217a of a projector 10b.

Specifically, the memory 217a differs from the memory 117a according the first embodiment of the present invention in characteristic approximations that are stored. Other configurations are similar to those of the first embodiment of the present invention.

### (Characteristic Approximation)

An error between a value of an IL characteristic (low-light-amount-region characteristic) expressed by a characteristic approximation according to the second embodiment of the present invention and a value of an IL characteristic (low-light-amount-region characteristic) actually measured is within a predetermined error-for example, within a target error range or the like established in advance. Moreover, the characteristic approximation according to the second embodiment of the present invention consists of a plurality of approximations for each section where the IL characteristic (low-light-amount-region characteristic) is divided by one or more division points and is calculated so a ratio of light outputs at corresponding one or more division points of each laser light-source 103 to 105 becomes a white balance ratio.

Here, the color components of the laser light-sources 103 to 105 are mutually-different color components as described above and are a red component, a blue component, and a green component. Moreover, numbers of the one or more division points in the characteristic approximation of each laser light-source 103 to 105 are the same. To be within the target error range is, for example, 2% or less.

The characteristic approximation according to the second embodiment of the present invention is specifically described below.

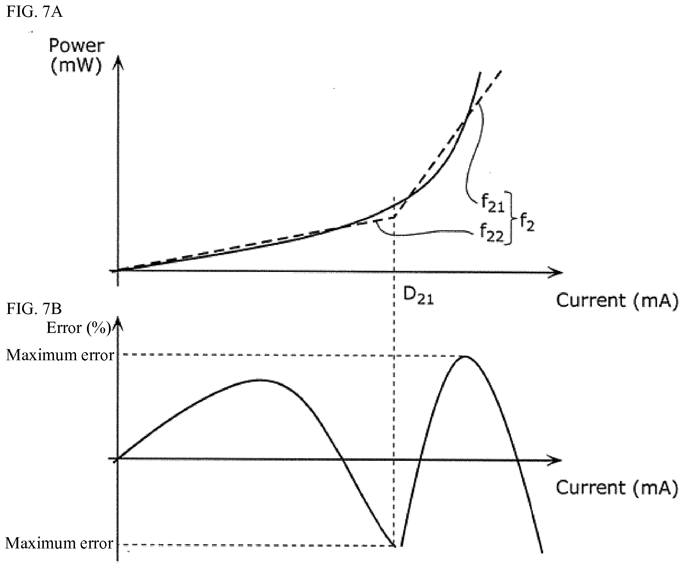

FIGS. 7A and 7B are graphs illustrating an example of the characteristic approximation of a laser light-source and an approximation error thereof.

In FIG. 7A, a characteristic approximation f₂ consisting of two linear approximations f₂₁, f₂₂ is illustrated by a dotted line and actually-measured characteristic values actually measured in the pre-shipment inspection are illustrated by a solid line. In FIG. 7B, an approximation error between the actually-measured characteristic values and characteristic values expressed by the characteristic approximation f₂ is illustrated. Here, the approximation error is an error calculated by ((approximation characteristic value expressed by characteristic approximation) - (actually-measured characteristic value)) / (actually-measured characteristic value) and indicates an error from a desired light output.

As illustrated in FIGS. 7A and 7B, the approximation error becomes a maximum (maximum error) at a division point D₂₁ and near a midpoint of a section sectioned by the division point D₂₁.

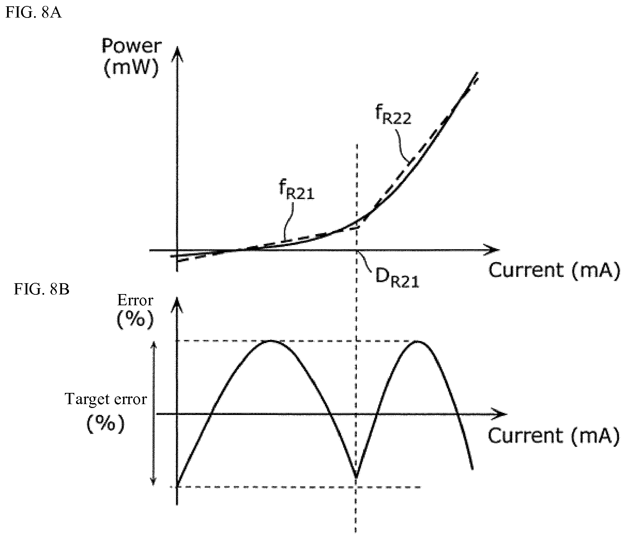

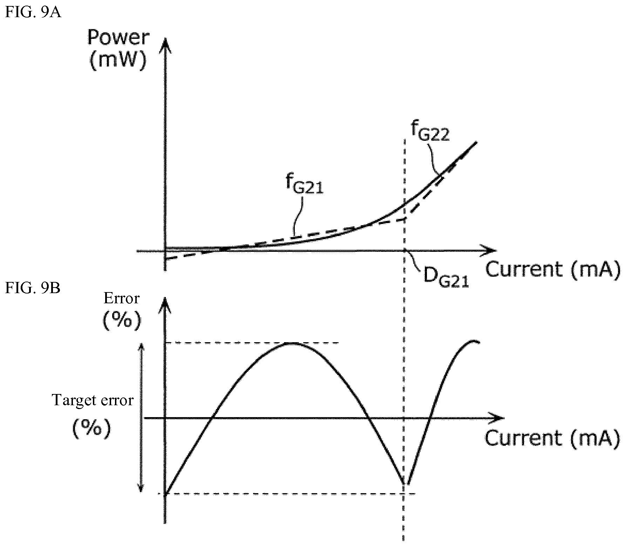

FIG. 8A is a graph illustrating an example of the characteristic approximation in the laser light-source of the red component. FIG. 8B is a graph illustrating an example of an approximation error of the characteristic approximation in the laser light-source of the red component. FIG. 9A is a graph illustrating an example of the characteristic approximation in the laser light-source of the green component. FIG. 9B is a graph illustrating an example of an approximation error of the characteristic approximation in the laser light-source of the green component.

As illustrated in FIGS. 8A, 8B, 9A, and 9B, for example, the characteristic approximation is calculated for each color component so the number of division points is minimized in a range where the error falls within the target approximation error such as within 2%. That is, calculation for each color component of the laser light-sources is a characteristic approximation individually optimized so that, for example, the error falls within the target approximation error such as within 2%.

However, because the characteristic of the laser light-source differs with each color component, the characteristic approximations individually optimized for each color component come to differ in positions of the division points and division counts.

Because of this, to perform dimming of the plurality of laser light-sources, in a situation of lowering the light outputs in the low-light-amount regions at the same ratio, a difference of ±2% maximum arises in the light outputs according to each color component; this destroys the color balance and may generate a color shift.

Therefore, in the second embodiment of the present invention, to reduce generation of the color shift, the division points of each color component are set.

This is specifically described below.

### (First Setting Method of Division Points)

To simplify description, a first setting method is described using an example where the plurality of color components is two components.

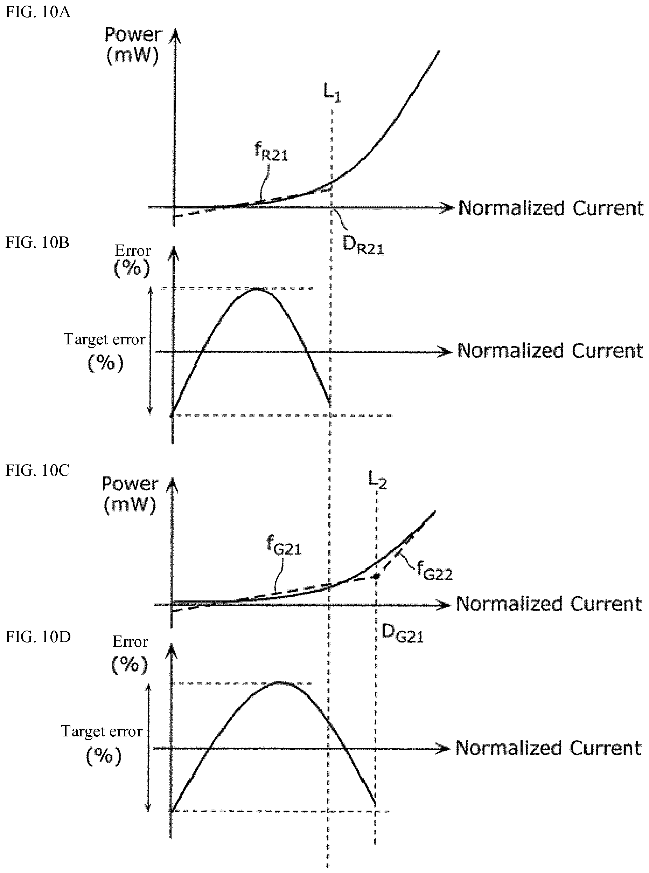

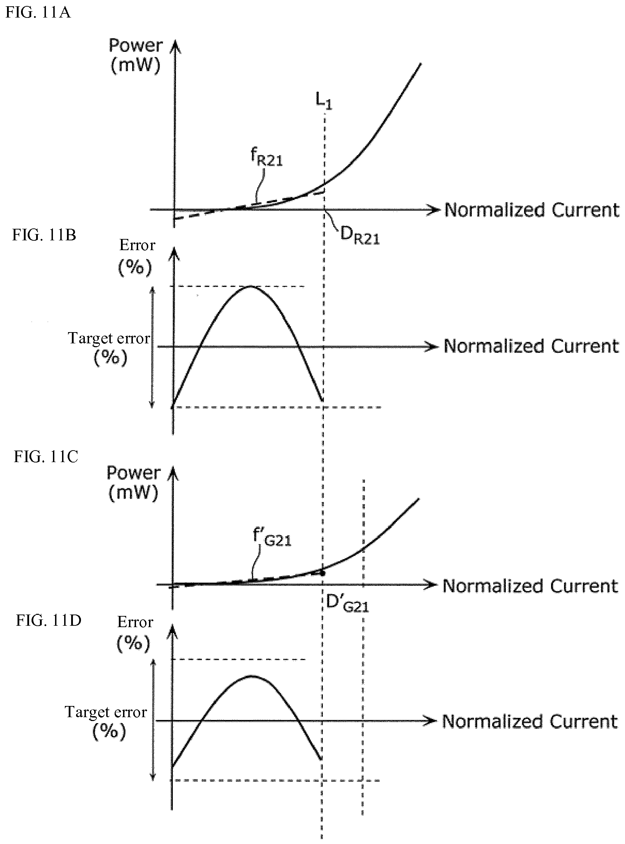

FIGS. 10A-10D are graphs illustrating examples of characteristic approximations in laser light-sources of two colors before adjustment and approximation errors thereof. FIG. 10A illustrates a characteristic approximation in the laser light-source of the red component before adjustment and actually-measured characteristic values, and FIG. 10B illustrates a graph of an approximation error in FIG. 10A. Similarly, FIG. 10C illustrates a characteristic approximation in the laser light-source of the green component before adjustment and actually-measured characteristic values, and FIG. 10D illustrates a graph of an approximation error in FIG. 10C. FIGS. 11A-11D are graphs illustrating examples of characteristic approximations in the laser light-sources of the two colors after adjustment and approximation errors thereof. FIG. 11A illustrates the characteristic approximation in the laser light-source of the red component after adjustment and the actually-measured characteristic values, and FIG. 11B illustrates a graph of an approximation error in FIG. 11A. Similarly, FIG. 11C illustrates the characteristic approximation in the laser light-source of the green component after adjustment and the actually-measured characteristic values, and FIG. 11D illustrates a graph of an approximation error in FIG. 11C.

As illustrated in FIGS. 10A-10D, because the respective characteristic approximations of the red component and the green component of the laser light-sources are individually optimized to fall within the target approximation errors, the positions of division points are different. For example, with a division point D_{R21} of the red component, a target error is maximized; meanwhile, with the green component, there is still room in a target error (target error at a position of L1 in FIGS. 10B and 10C).

Because of this, the characteristic approximation of the green component is recalculated with an upper limit current range of red (a current range of 0 to L1 in FIG. 10C) to obtain a characteristic approximation of the green component such as that illustrated in FIGS. 11C and 11D.

In this situation, as illustrated in FIG. 11D, a position of a division point D'_{G21} of the characteristic approximation of the green component becomes the position of L1, becoming the same position as the division point D_{R21} of the characteristic approximation of the red component. Moreover, the approximation error of the characteristic approximation of the green component is become within the target error.

In this manner, of the color components of the two colors, the characteristic approximation of the other color component is recalculated with a position where the characteristic value expressed by the characteristic approximation of the one color component becomes the target error as the position of the division point. In this situation, while the characteristic value expressed by the characteristic approximation of the other color component is smaller than the target error, the approximation is recalculated with the position thereof as the position of the division point.

Similarly, starting from the position of this division point, a position where the characteristic value expressed by the characteristic approximation of either color component from among the color components of the two colors is again recalculated as a division position. By repeating the recalculation above, the division points of the color components of the two colors can be calculated.

By calculating the division points in this manner, the numbers of the division points of the characteristic approximations of the color components of the two colors can be matched and the positions of the division points can be adjusted. By calculating (determining) the division points in this manner, a shift of another color component (for example, the green component) relative to a color component with a large shift (for example, the red component) becomes small, and the target error can be made to fall within the range of the color component with the large shift.

Note that the first setting method of the division points described above can be restated as follows.

That is, when the IL characteristics (relationships between the current values and the light output values) of the laser light-sources of the color components such as RGB are approximated, the division points of the other color components are determined by current values of division points decided by a laser light-source of a color component where a shift from a line obtained by approximation (a rectilinear line in the second embodiment of the present invention because the approximation is linear) arises in the smallest current section (a curve of the IL characteristic farthest from the rectilinear line).

By calculating (determining) the division points in this manner, the shift of another color component (for example, the green component) relative to a color component maximally shifted (for example, the red component) becomes small and falls within the range of the shift of the red component. In this manner, because the shift of the other color component can be made to fall within the range of the color component of the maximal shift, generation of the color shift can be reduced even when the low-brightness image is displayed on the display surface.

### (Second Setting Method of Division Points)

In a situation of performing dimming of laser light-sources of three colors of RGB, an RGB ratio must not be changed; even an error of about 1 to 2% is recognized as a color shift by the human eye. In the first setting method, one method of reducing generation of the color shift is described, but the error in the RGB ratio is not considered.

Therefore, in a second setting method, a method is described of calculating the division points in consideration of an error in the RGB ratio. More specifically, calculated is a characteristic approximation whose division points are set so the ratio of the light outputs at the corresponding one or more division points of the plurality of laser light-sources becomes the white balance ratio. In other words, in the second setting method, while deciding the division points to serve as reference is the same as the first setting method, a method of deciding the division points of the other color components differs from the first setting method. In the second setting method, after using the first setting method to decide the division points of a laser light-source of, for example, the red component as the division points to serve as reference, the division points of laser light-sources of the other color components are decided relative to the light amounts at these division points in consideration of the white balance. For example, supposing the red component to have a wavelength of 644 nm, the green component to wave a wavelength of 515 nm, and the blue component to be B: 450 nm, because the white balance is R:G:B = 2.67:1:1.66 and the blue and green light amounts of this ratio are unambiguously decided relative to the red light amount of the division points, the current values of this light amount can be made the blue and green division points. Note that in the second setting method, the division points can be output at the same timing by performing dimming in consideration of the white balance. That is, when the white balance is considered, variation at the division points is continuously maximal, but because the variation of red serving as reference becomes the greatest, the variation of the other color components can be suppressed to be within this variation.

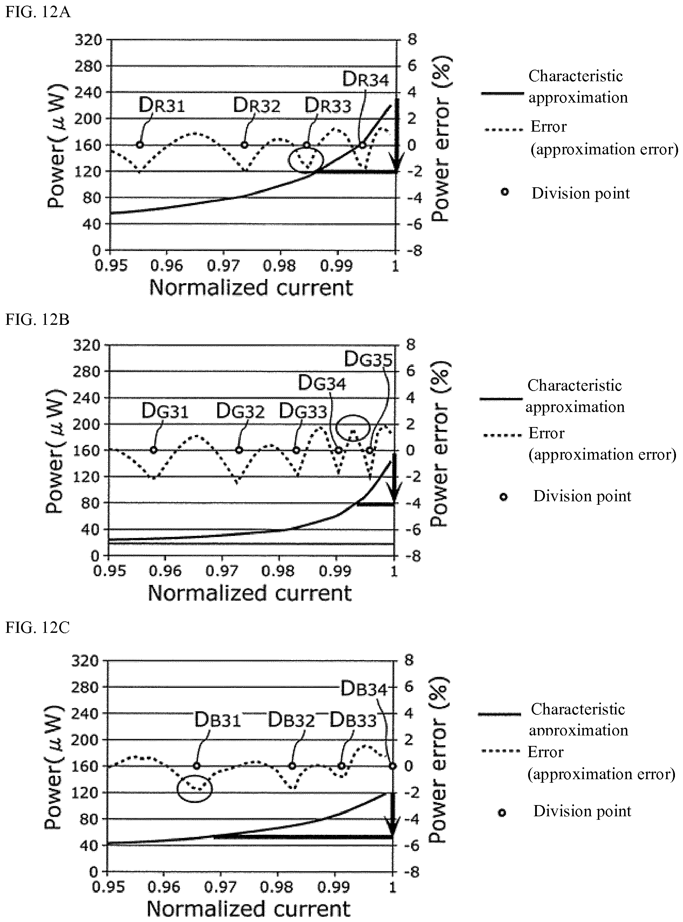

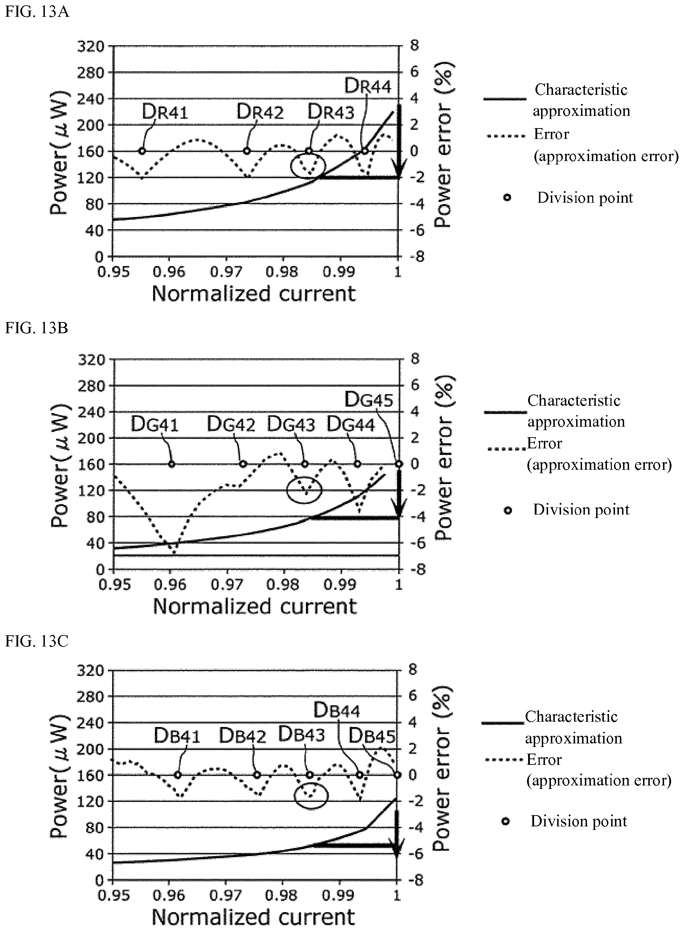

Described below are the variations (errors) in a situation where the division points are not determined (calculated) by the second setting method using FIG. 12A to FIG. 12C and the variation (errors) in a situation where the division points are determined (calculated) by the second setting method using FIG. 13A to FIG. 13C.

FIG. 12A is a graph illustrating an example of the characteristic approximation, the division points, and the approximation error in the red laser light-source before adjustment. FIG. 12B is a graph illustrating an example of the characteristic approximation, the division points, and the approximation error in the green laser light-source before adjustment. FIG. 12C is a graph illustrating an example of the characteristic approximation, the division points, and the approximation error in the blue laser light-source before adjustment. FIG. 13A is a graph illustrating an example of the characteristic approximation, the division points, and the approximation error in the red laser light-source after adjustment. FIG. 13B is a graph illustrating an example of the characteristic approximation, the division points, and the approximation error in the green laser light-source after adjustment. FIG. 13C is a graph illustrating an example of the characteristic approximation, the division points, and the approximation error in the blue laser light-source after adjustment.

FIG. 12A to FIG. 12C illustrate approximation errors of a situation where the division points of each color component are individually calculated without using the second setting method - that is, a situation where calculated are division points (D_{R31} to D_{R34}, D_{G31} to D_{G35}, D_{B31} to D_{B34}) of characteristic approximations individually optimized in each color component so a chromaticity falls within an error range (target approximation error) of within ±0.005 and ±2%. As illustrated in FIG. 12A to FIG. 12C, with each color component, the positions and the division counts of the division points differ. Here, the red component has the wavelength of 644 nm, the green component has the wavelength of 515 nm, and the blue component has the wavelength of 450 nm.

In this situation, each output is decided with an aim of achieving overall a target brightness; therefore, when dimming (synthesis) is performed at a light output at the division point D_{R33} with the red component, a light output at a midway point between the division point D_{G35} and the division point D_{G35} with the green component, and a light output at the division point D_{B31} with the blue component, a color shift of x: -0.003, y: 0.005 arises. This arises because an error between the characteristic approximation and the actually-measured value at the division point D_{R33} of the red component is -2%, an error between the characteristic approximation and the actually-measured value at the midway point between the division point D_{G35} and the division point D_{G35} of the green component is +2%, and an error between the characteristic approximation and the actually-measured value at the division point D_{B31} of the blue component is -2%.

Meanwhile, in FIG. 13A to FIG. 13C, the division points of each color component are calculated by the second setting method to be in dispositions where a light output ratio at these division points maintains the white balance. Because of this, the division counts are also calculated to be the same number for each color component.

For example, the division points are calculated (determined) so white is achieved when the light output at the division point D_{R43} of the red component, the light output at the division point D_{G43} of the green component, and the light output at the division point D_{B43} of the blue component are synthesized. As a result, an error between the characteristic approximation and the actually-measured value at the division point D_{R43} of the red component is -2%, an error between the characteristic approximation and the actually-measured value at the division point D_{G43} of the green component is -2%, and an error between the characteristic approximation and the actually-measured value at the division point D_{B43} of the blue component is -2%, and the errors between the approximations and the actually-measured values match in the same direction (direction of +, -). Because of this, in a situation of controlling currents of the laser light-sources of the three colors RGB at the same timing based on the approximations (that is, controlling the light amounts while retaining the RGB ratio configuring white), because an error from white can be kept within the target approximation error, generation of the color shift can be suppressed.

Note that in the examples illustrated in FIG. 13A to FIG. 13C, dimming is performed with a target of making a brightness 50%, but the brightness is actually become 49%. However, a shift in the brightness is less likely to trouble persons and is unproblematic.

### (Effects)

As described above, the projector 10b according to the second embodiment of the present invention may control the respective outputs of the laser light-sources 103 to 105 by using the characteristic approximations, which approximate the IL characteristics of the low-light-amount regions (low-light-amount-region characteristics) of the actual measurement values measured in advance, even in the regions of the low light amounts (low brightness) smaller than the light amounts of the light outputs that cannot be measured by the photodiodes 109 to 111.

By this, the projector 10b according to the second embodiment of the present invention may reduce generation of the color shift even when the low-brightness image is displayed on the display surface.

### (Third Embodiment)

Characteristics of a laser light-source change due to a temperature change, degradation over time, and the like. Because of this, in a situation where the characteristic of a laser light-source changes due to a temperature change or degradation over time, there is a need to correct the characteristic approximation. This situation is described in a third embodiment of the present invention.

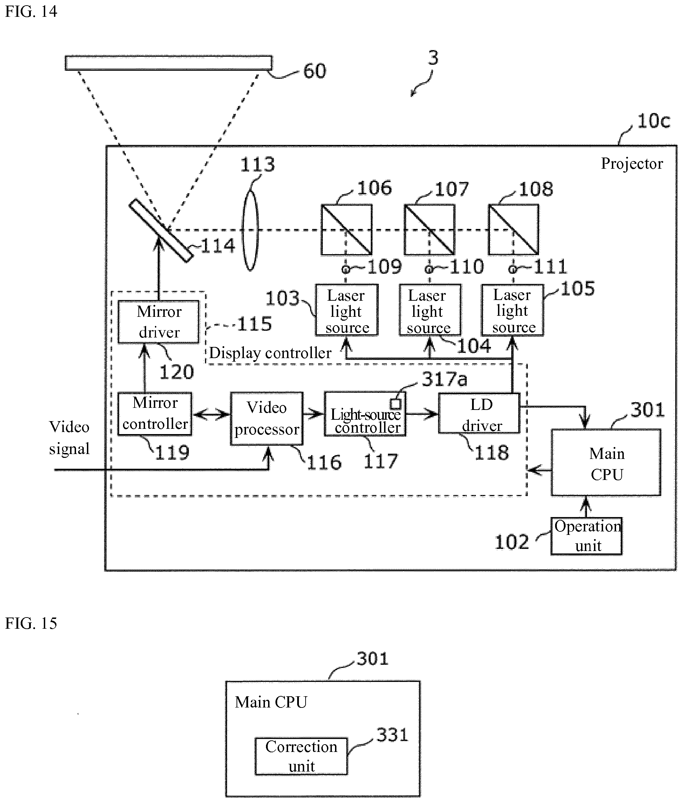

FIG. 14 is a block diagram illustrating an example of a configuration of a HUD device according to the third embodiment of the present invention. Elements similar to those in FIG. 6 are labeled with the same reference signs, and detailed description is omitted. FIG. 15 is a block diagram illustrating a configuration of a main CPU according to the third embodiment of the present invention.

A HUD device 3 illustrated in FIG. 14 differs from the HUD device 2 according to the second embodiment of the present invention in a configuration of a memory 317a of a projector 10c and differs in that a main CPU 301 includes a correction unit 331 as illustrated in FIG. 15.

The memory 317a may differ from the memory 217a according to the second embodiment of the present invention in characteristic approximations that are stored. More specifically, with the memory 317a, the characteristic approximation described in the second embodiment of the present invention may be corrected by the correction unit 331.

The correction unit 331 corrects the characteristic approximation. Specifically, in a situation where a relationship of a light output relative to a forward current value of each laser light-source 103 to 105 received by each photodiode 109 to 111 is changed, the correction unit 331 corrects the characteristic approximation of each laser light-source 103 to 105. In the situation where the relationship of the light output relative to the forward current value in each laser light-source 103 to 105 received by each photodiode 109 to 111 is changed, the correction unit 331 corrects the characteristic approximation of each laser light-source 103 to 105 to become values continuous with a lower limit indicated by the relationship of the light output relative to the forward current.

Note that because other configurations are similar to those of the second embodiment of the present invention, other description is omitted.

### (Characteristic Approximation)

The characteristic approximation that is corrected is described below.

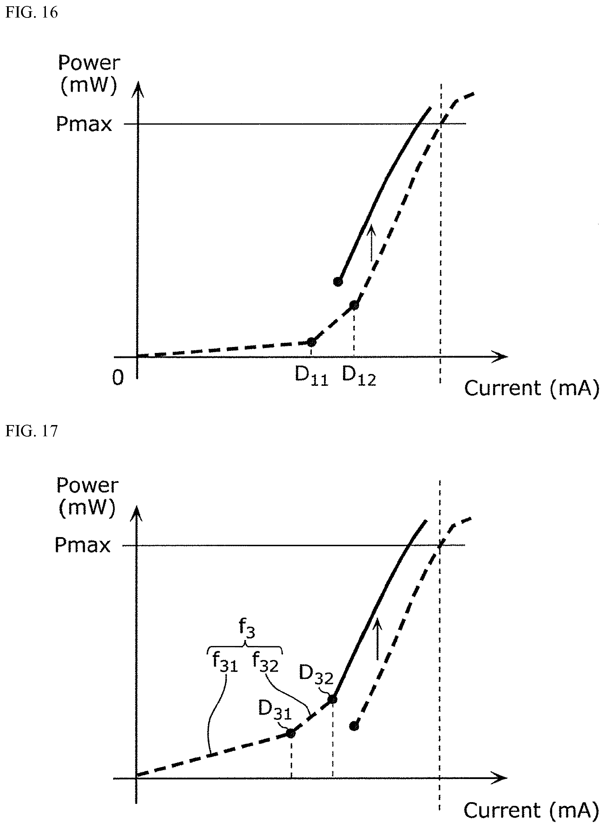

FIG. 16 is a graph illustrating an example of a characteristic of a laser light-source that changes according to a temperature change or the like. FIG. 17 is a graph illustrating an example of the characteristic approximation of the laser light-source corrected by the correction unit according to third embodiment.

FIG. 16 illustrates by a dotted line an example of a characteristic of a laser light-source that can be measured by a photodiode and a characteristic approximation thereof before the characteristic changes due to a temperature change. The characteristic of the laser light-source that can be measured by the photodiode after the characteristic changes due to the temperature change is illustrated by the solid line.

As illustrated in FIG. 16, the characteristic of the laser light-source changes due to the temperature change. The characteristic of the laser light-source that can be measured by the photodiode can be acquired by following the temperature change, but because the characteristic approximation is calculated by the characteristic of the laser light-source actually measured in the pre-shipment inspection, the characteristic approximation does not follow the change of the characteristic due to this temperature change.

Because of this, in the third embodiment of the present invention, as illustrated in FIG. 17, the correction unit 331 corrects the characteristic approximation of this laser light-source so it takes on values continuous with the characteristic of the laser light-source that can be measured by the photodiode.

A characteristic approximation f₃ after correction illustrated in FIG. 17 consists of linear expressions f₃₁, f₃₂ that are approximations for each section divided by division points D₃₁, D₃₂. This is because the plurality of approximations configuring the characteristic approximation is corrected by maintaining the division count (division points D₁₁, D₁₂) of the characteristic approximation before correction illustrated in FIG. 16 and enlarging or shrinking the sections divided by the division points D₁₁, D₁₂.

### (Effects)

As described above, the projector 10c according to the third embodiment of the present invention may control the respective outputs of the laser light-sources 103 to 105 by using the characteristic approximations, which approximate the IL characteristics of the low-light-amount regions (low-light-amount-region characteristics) of the actual measurement values measured in advance, even in the regions of the low light amounts (low brightness) smaller than the light amounts of the light outputs that cannot be measured by the photodiodes 109 to 111.

Furthermore, because even in a situation where an output characteristic shifts by a change in a temperature or a change over time the characteristic approximation can be corrected in correspondence thereto, a continuity between a region of light amounts that can be measured by the photodiodes 109 to 111 and a region of low light amounts that cannot be measured by the photodiodes 109 to 111 can be ensured for a smooth brightness change.

By this, the projector 10 according to the third embodiment of the present invention may reduce generation of the color shift of the low-brightness image displayed on the display surface even in a situation where the output characteristic shifts by the change in the temperature or the change over time.

### (Modified Example)

The third embodiment of the present invention described above describes a situation of correcting the characteristic approximation of the second embodiment of the present invention but is not limited thereto. It may correct the characteristic approximation of the first embodiment of the present invention.

### (Other Embodiments)

HUD devices according to one or more embodiments of the present invention are described above, but the present invention is not limited to these embodiments of the present invention.

For example, of the projector 10 (20, 30) above, the main CPU 101 (301), the video processor 116, the light-source controller 117, and the mirror controller 119 may be configured as a computer system specifically configured from a microprocessor, a ROM, a RAM, a hard-disk drive, a display unit, a keyboard, a mouse, and the like. A computer program is stored in the RAM or the hard-disk drive. These processors achieve functions thereof by the microprocessor operating according to the computer program. Here, the computer program is configured by a plurality of command codes being combined indicating an instruction to a computer to achieve a predetermined function.

Furthermore, a portion or an entirety of components configuring each device above may be configured from one system LSI (large-scale integration). The system LSI is a super multifunctional LSI manufactured by stacking a plurality of configuring portions on one chip and includes a computer system configured including, for example, a microprocessor, a ROM, a RAM, and the like. In this situation, a computer program is stored in the ROM. The system LSI achieves a function thereof by the microprocessor operating according to the computer program.

Still furthermore, a portion or the entirety of the components configured each device above may be configured from an IC card that can be detached from each device or a single module. The IC card or the module is a computer system configured from a microprocessor, a ROM, a RAM, and the like. The IC card or the module may include the super multifunctional LSI above. The IC card or the module achieves a function thereof by the microprocessor operating according to a computer program. This IC cards or this module may be tamper resistant.

Furthermore, one or more embodiments of the present invention may be a method illustrated above. Moreover, one or more embodiments of the present invention may be a computer program that realizes these methods by a computer or a digital signal consisting of the computer program.

Furthermore, one or more embodiments of the present invention may be a recording of the computer program or the digital signal on a non-temporary recording medium that can be read by a computer such as a flexible disk, a hard disk, a CD-ROM, an MO, a DVD, a DVD-ROM, a DVD-RAM, a BD (Blu-ray (registered trademark) Disc), or a semiconductor memory. Moreover, it may be the digital signal recorded on these non-temporary recording media.

Furthermore, one or more embodiments of the present invention may be a transmission of the computer program or the digital signal over a network, a data broadcast, or the like represented by a telecommunication line, a wireless or wired communication line, and the Internet.

Furthermore, one or more embodiments of the present invention may be a computer system including a microprocessor and a memory wherein the memory stores the computer program and the microprocessor operates according to the computer program.

Furthermore, implementation may be by another independent computer system by recording the program or the digital signal on the non-temporary recording medium and transferring it or transferring the program or the digital signal over the network or the like.

Furthermore, the above embodiments of the present invention and the above modified examples may be combined with each other.

Although the disclosure has been described with respect to only a limited number of embodiments, those skilled in the art, having benefit of this disclosure, will appreciate that various other embodiments may be devised without departing from the scope of the present invention. Accordingly, the scope of the invention should be limited only by the attached claims.
1, 2, 3 HUD device
10, 10b, 10c Projector
20 Windshield
50 Automobile
60 Combiner
61 Route information
62 Distance information
101,301 Main CPU
102 Operation unit
103, 104, 105 Laser light-source
106, 107, 108 Beam splitter
109, 110, 111 Photodiode
113 Lens
114 MEMS mirror
115 Display controller
116 Video processor
117 Light-source controller
117a, 217a, 317a Memory
118 LD driver
119 Mirror controller
120 Mirror driver
121 Controller
331 Correction unit

## Claims

1. A projector, comprising:
a plurality of light-sources (103, 104, 105) that outputs a laser light;
a detector that detects a light amount of the laser light; and
a controller (117) that controls an output of the light-sources based on a characteristic indicating a relationship between a forward current value and a light output when a current value of the light-sources is smaller than a predetermined current value.

2. The projector according to claim 1, wherein when the current value of the light-sources (103, 104, 105) is greater than or equal to the predetermined current value, the controller (117) controls the output of the light-sources based on the detected light amount.

3. The projector according to claim 1 or 2, wherein the controller (117) performs control based on a table acquired in advance indicating the relationship between the forward current value and the light output.

4. The projector according to any one of claims 1 to 3, wherein the predetermined current value is a current value that can be laser-oscillated.

5. The projector according to any one of claims 1 to 4, wherein the predetermined current value is set individually in each of the plurality of light-sources (103, 104, 105).

6. The projector according to any one of claims 1 to 5, wherein the controller (117) controls each of the outputs of the plurality of light-sources (103, 104, 105) using an approximation that approximates the characteristic corresponding to each of the plurality of light-sources.

7. The projector according to claim 6, wherein the approximation is different for each section where the characteristic is divided by at least a division point.

8. The projector according to claim 7, wherein the division point is an inflection point that connects the different approximations.

9. The projector according to claim 7, wherein a ratio of the outputs of the plurality of light-sources (103, 104, 105) at the division point is a white balance ratio.

10. The projector according to any one of claims 1 to 9, further comprising:
a memory (117a, 217a, 317a) that stores the characteristic in advance in a predetermined period.

11. The projector according to claim 7, wherein current values of the plurality of light-sources (103, 104, 105) at the division point are identical.

12. The projector according to claim 7, further comprising:
a correction unit (331) that corrects a characteristic approximation consisting of the different approximations for the sections,
wherein the correction unit (331) corrects each of the characteristic approximations of the plurality of light-sources (103, 105, 107) based on change of a relationship of the light output relative to the forward current value in each of the plurality of light-sources.

13. The projector according to any one of claims 1 to 12, further comprising:
a LD driver (118) that supplies a drive current to the light-sources (103, 104, 105),
wherein the controller (121) controls the LD driver to control the output of the light-sources.

14. A head-up display device including the projector according to any one of claims 1 to 13.
